(19) **Europäisches Patentamt European Patent Office Office européen des brevets**

(11) **EP 4 490 674 B1**

(12) **FASCICULE DE BREVET EUROPEEN**

(45) Date de publication et mention de la délivrance du brevet:
**05.08.2026 Bulletin 2026/32**

(21) Numéro de dépôt: **23709443.8**

(22) Date de dépôt: **09.03.2023**

(51) Classification Internationale des Brevets (IPC):
**G06N 10/40** *(2022.01)* **G06N 10/70** *(2022.01)*
**H03K 3/38** *(2006.01)*

(52) Classification Coopérative des Brevets (CPC):
**G06N 10/40; G06N 10/70; H03K 3/38**

(86) Numéro de dépôt international:
**PCT/EP2023/056074**

(87) Numéro de publication internationale:
**WO 2023/170234 (14.09.2023 Gazette 2023/37)**

(54) **STABILISATION AUTONOME D'UN CODE GKP PAR MODULATION PARAMÉTRIQUE EN PEIGNE DE FRÉQUENCES MICROONDES**

SELBSTSTABILISIERUNG EINES GKP CODES DURCH PARAMETRISCHE MODULATION IN EINEM MIKROWELLENFREQUENZKAMM

SELF-STABILISATION OF A GKP CODE BY PARAMETRIC MODULATION IN A MICROWAVE FREQUENCY COMB

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **10.03.2022 FR 2202121**

(43) Date de publication de la demande:
**15.01.2025 Bulletin 2025/03**

(73) Titulaires:
- **Institut National de Recherche en Informatique et en Automatique**
  **78153 Le Chesnay-Rocquencourt Cedex (FR)**
- **Association pour la Recherche et le Développement**
  **des Méthodes et Processus Industriels - ARMINES**
  **75272 Paris, Cedex 06 (FR)**

(72) Inventeurs:
- **CAMPAGNE-IBARCQ, Philippe**
  **78150 Le Chesnay (FR)**
- **MIRRAHIMI, Mazyar**
  **78150 Le Chesnay (FR)**
- **SARLETTE, Alain**
  **78150 Le Chesnay (FR)**
- **ROUCHON, Pierre**
  **75272 Paris, Cedex 06 (FR)**

(74) Mandataire: **Vidon Brevets & Stratégie**
  **16B, rue de Jouanet**
  **35700 Rennes (FR)**

(56) Documents cités:
- **ARNE L GRIMSMO ET AL: "Quantum Error Correction with the Gottesman-Kitaev-Preskill Code", ARXIV.ORG, CORNELL UNIVERSITY LIBRARY, 201 OLIN LIBRARY CORNELL UNIVERSITY ITHACA, NY 14853, 24 June 2021 (2021-06-24), XP081994399, DOI: 10.1103/ PRXQUANTUM.2.020101**
- **CAMPAGNE-IBARCQ P ET AL: "A stabilized logical quantum bit encoded in grid states of a superconducting cavity", ARXIV.ORG, CORNELL UNIVERSITY LIBRARY, 201 OLIN LIBRARY CORNELL UNIVERSITY ITHACA, NY 14853, 29 July 2019 (2019-07-29), XP081451014**

EP 4 490 674 B1

**Description**

L'invention concerne le domaine des circuits quantiques à résonateur microonde supraconducteur, et en particulier mettant en œuvre un code correcteur quantique utilisant un code bosonique.

La réalisation d'un ordinateur quantique est à ce jour empêchée par le bruit modifiant l'état des bits quantiques (ci-après qubits), causant des erreurs logiques. Malgré de grands progrès réalisés depuis 20 ans pour limiter les sources de bruit, le calcul quantique universel et tolérant à l'erreur est actuellement hors de portée. La correction d'erreur quantique vise à résoudre ce problème.

Le type d'erreur logique à corriger présente deux natures : les erreurs de bit ('bit flip' en anglais) et les erreurs de phase ('phase flip' en anglais). La principale méthodologie utilisée vise à encoder quelques qubits logiques dans un espace informationnel beaucoup plus vaste. Dans cet espace informationnel, les qubits sont encodés dans des états dits « codants », qui sont choisis de sorte que le bruit ne permette pas d'induire une transition directe d'un état codant vers un autre.

Le bruit, qui induit ainsi des transitions d'un état codant vers un état non-codant, peut être détecté et corrigé pour ramener le système vers l'état codant initial de manière non ambiguë, c'est-à-dire que chaque état non-codant est associé à un unique état codant. Pour ne pas perturber l'information quantique, cette détection et correction d'erreur doit se faire sans mesure des qubits logiques.

La méthode de correction d'erreur quantique la plus répandue s'appelle « code de surface » ('*Surface code'* en anglais). Ce type de solution est mis en œuvre par les plus grands noms du domaine quantique, comme Google, IBM, l'Université de Delft, l'Université de Zurich, etc., et constitue la solution la plus étudiée dans le monde à ce jour.

Dans un code de surface, l'information quantique est portée par un réseau 2D de systèmes à deux niveaux. Des portes à un et deux qubits tolérantes à l'erreur existent. Le plus grand inconvénient de cette technologie est qu'elle nécessite un grand nombre de systèmes à deux niveaux de très bonne qualité pour permettre de réaliser un calcul. Au-delà des coûts induits par cette architecture, cela génère des problèmes liés à la nécessité de contrôler un grand nombre de systèmes quantiques.

Les travaux de la Demanderesse l'ont amené à considérer que les codes de surface présentent des désavantages nécessitant d'explorer d'autres solutions. Pour cette raison, la Demanderesse a étudié les codes bosoniques.

Les codes bosoniques sont une famille de codes de correction d'erreur quantique qui reposent sur le stockage des qubits dans des modes bosoniques. Ces codes comprennent trois principales sous-familles : les codes 'cat' (chat), les codes binomiaux, et les codes GKP (pour Gottesman-Kitaev-Preskill).

Un exemple des codes cat sont les codes de chat de Schrödinger à deux pattes mis en œuvre par l'Université de Yale, l'équipe Quantic, ou encore des sociétés comme Quantum Computing Inc, Alice & Bob, ou Amazon Web Services.

Dans ces codes, les états codants sont des états chat de Schrödinger. Contrairement au code GKP, Seul un des deux types d'erreur logique peut-être supprimé. Il faut donc concaténer ce code dans un code de répétition pour pouvoir gérer les deux types d'erreur logique.

Un avantage de ces codes par rapport au code GKP est que la suppression de l'un des deux types d'erreurs peut être rendue arbitrairement bonne en variant simplement la taille du chat. Cela n'est pas possible avec les codes GKP, pour lesquels seule l'augmentation du ratio entre les taux de dissipation induite par conception (ou cadence de mesure et correction dans le cas d'une stabilisation par la mesure) et la dissipation intrinsèque du résonateur permet d'allonger exponentiellement le temps de vie du qubit logique.

Un autre exemple sont les codes de chat de Schrödinger à n>2 pattes mis en œuvre par l'Université de Yale et Quantum Computing Inc. Contrairement aux codes de chat de Schrödinger à 2 pattes, les deux types d'erreur logique peuvent-être corrigés. Cependant, la suppression ne suit pas une loi exponentielle mais polynomiale lorsque la cadence de détection de correction ou le taux de dissipation induite par conception sont augmentés.

Les codes binomiaux présentent pour leur part des problèmes similaires à ceux des chats de Schrödinger à n>2 pattes. Ils ne protègent par ailleurs que contre les pertes de photons, et non d'autres type de bruits comme le déphasage pur.

Les codes GKP présentent également plusieurs mises en œuvre. Un premier exemple est un code GKP stabilisé par des interactions de Rabi avec un qubit ancillaire mis en œuvre par l'Université de Yale en partenariat avec l'équipe Quantic. Cette méthode induit des erreurs logiques, par exemple lorsque le qubit ancillaire subit un type d'erreur modifiant son état selon l'axe de la sphère de Bloch correspondant à l'opérateur présent dans l'interaction de Rabi pendant l'interaction. Il est possible de les supprimer en utilisant un qubit ancillaire dont l'une des erreurs est supprimée (par exemple, un chat de Schrödinger), mais cette méthode est complexe à mettre en œuvre et à ce jour non réalisée expérimentalement.

Un autre exemple est un code GKP stabilisé par des opérateurs modulaires. Il existe des propositions pour implémenter une dynamique Hamiltonienne portée par des opérateurs modulaires qui, combinée à une dissipation à un photon simple, stabilise le code GKP. Les circuits proposés pour implémenter cette dynamique ne sont cependant pas réalisables. En effet, soit ils impliquent un élément dit « *coherent phase-slip element* »,

soit ils impliquent un « gyrateur de haute impédance », dont aucune implémentation n'a encore été démontrée à ce jour.

GRIMSMO ET AL: "Quantum Error Correction with the Gottesman-Kitaev-Preskill Code", ARXIV.ORG, propose une vue d'ensemble du code GKP en mettant l'accent sur sa mise en œuvre en circuit-QED.

CAMPAGNE-IBARCQ P ET AL: "A stabilized logical quantum bit encoded in grid states of a superconducting cavity", ARXIV.ORG, présente une démonstration expérimentale de la stabilisation continue d'états GKP dans une cavité micro-onde supraconductrice, par modulation stroboscopique de l'interaction cavité-transmon.

Aucun code correcteur ne fonctionne donc de manière satisfaisante à ce jour. Pour les plus avancés, le point auquel les qubits logiques ont un temps de vie/de cohérence plus long que les systèmes physiques sous-jacents a à peine été atteint, mais n'a jamais été dépassé de manière significative.

L'invention vient améliorer la situation. À cet effet, elle propose un circuit supraconducteur quantique à gamme microonde comprenant un élément à jonction Josephson à énergie réglable relié à une portion de circuit passive linéaire présentant plusieurs modes résonants dont la décomposition de Foster de première forme aux bornes de l'élément à jonction Josephson comprend un mode résonant cible présentant une impédance Z supérieure à 13 kOhms et une pulsation w. L'énergie dudit élément à jonction Josephson est réglable et modulée par au moins deux trains d'impulsions respectifs au sein desquels les impulsions sont séparées par une durée $2\pi/w$ et présentent une largeur inférieure à un dixième de cette durée, l'amplitude des impulsions au sein de chaque train d'impulsions respectif étant modulée par une porteuse sinusoïdale respective et les trains d'impulsions étant décalés deux à deux respectivement d'une durée $\Delta t$ telle que $|\sin(w*\Delta t)|$ vaut 13 kOhms/Z, de sorte que le mode résonant de pulsation w se stabilise dans un de deux états GKP encodant un qubit.

Ce dispositif est particulièrement avantageux car il permet de de mettre en œuvre des opérateurs modulaires pour la mise en œuvre d'un qubit dans un code GKP, qui peut être stabilisé de manière fiable et permettant une amélioration considérable du rapport entre le temps de cohérence et le temps de porte par rapport à tous les qubits implémentés jusqu'à présent.

Selon divers modes de réalisation, l'invention peut présenter une ou plusieurs des caractéristiques suivantes :

- la pulsation wi de la porteuse sinusoïdale de chaque train d'impulsions respectif est nulle, de sorte que les états codants GKP soient les états de plus basse énergie dans une représentation d'interaction abaissant la pulsation du mode résonant cible à une pulsation inférieure à un cinquième de l'amplitude du potentiel effectif modulaire généré pour le mode résonant cible divisée par la constante de Planck réduite, lesdits états de plus basse énergie étant stabilisés par couplage à un environnement dont le produit de la constante de Boltzmann par la température effective est inférieure à l'énergie Josephson dans cette représentation,

- la pulsation wi de la porteuse sinusoïdale de chaque train d'impulsions respectif est une pulsation d'un des modes résonants de la décomposition de Foster aux bornes de l'élément à jonction Josephson de la portion de circuit passive linéaire différente de la pulsation w, le circuit supraconducteur quantique à gamme microonde comprenant en outre un organe de mesure linéaire homodyne des modes résonants correspondants aux pulsations wi respectives, agencé pour mesurer les déplacements des modes résonants de pulsation wi selon une direction de leur plan de phase respectif déterminée par la phase de la porteuse sinusoïdale de pulsation wi, et un organe de rétroaction agencé pour déplacer l'état du mode résonant cible selon une direction de son plan de phase déterminée par la phase du train d'impulsions correspondant à la pulsation wi par rapport à la référence de phase dudit mode résonant cible, de manière proportionnée à une mesure reçue de l'organe de mesure,

- la pulsation wi de la porteuse de chaque train d'impulsions respectif est une pulsation d'un des modes résonants de la décomposition de Foster de la première forme aux bornes de l'élément à jonction Josephson de la portion de circuit passive linéaire différente de la pulsation w, la portion de circuit passive linéaire étant agencée de sorte que lesdits modes résonants de pulsation wi dissipent leurs excitations respectives dans un environnement dont le produit de la température par la constante de Boltzmann est inférieure au produit de la pulsation wi par la constante de Planck réduite et selon un taux supérieur à $\sqrt{(w/4 * Z_i/(6,5\ kOhms))} * e_i$ où Zi est l'impédance du mode de pulsation wi aux bornes de l'éléments dudit élément à jonction Josephson et ei est l'énergie Josephson moyenne intégrée sur la durée d'une impulsion, chaque impulsion étant précédée d'une pré-impulsion et suivie d'une post-impulsion, la pré-impulsion et la post-impulsion étant modulées par une porteuse sinusoïdale en quadrature avec la porteuse de l'impulsion et étant décalée par rapport à l'impulsion d'une durée respective $\delta$ inférieure à $1/(5w)$ et présentant une amplitude opposée et de valeur absolue inférieure à $1/(3\delta w)$,

- les trains d'impulsions respectifs sont activés dans des fenêtres temporelles se chevauchant, et les pulsations des porteuses sinusoïdales qui modulent leurs amplitudes respectives sont distinctes,

- les trains d'impulsions respectifs sont activés l'un après l'autre et sont modulés par la même porteuse sinusoïdale de pulsation wi, de sorte qu'un train d'impulsions se terminent avant l'activation du train suivant, chaque train comprenant un nombre d'impulsion compris entre 10 et 10^8,

- l'élément à jonction Josephson présente une phase réglable permettant de modifier la position de la grille d'états GKP,
- l'impédance du mode résonant cible est ajustable, et le décalage entre les trains d'impulsions respectifs peut être adapté pour permettre de modifier la forme de la maille de la grille d'états GKP,
- l'impédance du mode résonant cible est égale à 13 kOhms, la pulsation du mode résonant cible est modifiée afin de réaliser une rotation de $\pi/2$ de la grille d'états GKP, et la durée entre les impulsions au sein d'un même train est modifiée de manière adaptée à cette pulsation modifiée,
- l'impédance du mode résonant cible est égale à 15 kOhms, la pulsation du mode résonant cible est modifiée afin de réaliser une rotation de $\pi/3$ de la grille d'états GKP, et la durée entre les impulsions au sein d'un même train est modifiée de manière adaptée à cette pulsation modifiée,
- le circuit comprend deux éléments à jonction Josephson à énergie réglable, chacun relié à ladite portion de circuit passive linéaire de telle sorte que l'impédance du mode résonant cible présentée à au moins un des deux éléments à jonction Josephson est ajustable, l'énergie de chaque élément à jonction Josephson étant réglable et modulée en fonction de chaque impédance respective du mode résonant cible,
- le circuit comprend deux circuits dont l'un au moins est tel que décrit précédemment reliés entre eux de manière à définir une porte logique, et
- les deux circuits présentent une impédance du mode résonant cible ajustable, le décalage entre les trains d'impulsions respectifs pouvant être adapté pour permettre de modifier la forme de la maille de la grille d'états GKP, et la portion de circuit passive linéaire de chaque circuit étant reliée à l'élément à jonction Josephson de l'autre circuit par un coupleur ajustable de manière à régler l'impédance du mode résonant cible de chaque circuit présentée à l'élément à jonction Josephson de l'autre circuit.

D'autres caractéristiques et avantages de l'invention apparaîtront mieux à la lecture de la description qui suit, tirée d'exemples donnés à titre illustratif et non limitatif, tirés des dessins sur lesquels :

- [Fig.1] est une représentation des fonctions d'onde des états d'un code GKP,

- [Fig.2] est une représentation d'un circuit quantique à résonateur microonde supraconducteur selon un premier mode de réalisation de l'invention,

- [Fig.3] représente le profil temporel d'activation des jonctions Josephson de la figure 2 lorsque la décomposition de Foster de première forme aux bornes de l'élément à jonction Josephson comprend un mode résonant cible présentant une impédance Z égale à 13 kOhms,

- [Fig.4] représente les déplacements de l'état du mode résonant cible du circuit de la figure 2 dans un référentiel de laboratoire et dans un référentiel tournant, lorsque la décomposition de Foster de première forme aux bornes de l'élément à jonction Josephson comprend un mode résonant présentant une impédance Z égale à 13 kOhms,

- [Fig.5] représente une variante de la figure 3 lorsque l'impédance Z est supérieure à 13 kOhms,

- [Fig.6] représente une variante de la figure 4 lorsque l'impédance Z est supérieure à 13 kOhms,

- [Fig.7] représente une implémentation dite Hamiltonienne du circuit de la figure 2,

- [Fig.8] représente le profil temporel d'activation des jonctions Josephson de la figure 7,

- [Fig.9] représente les potentiels effectifs générés au moyen du circuit de la figure 7 dans un référentiel tournant, ainsi que la densité de probabilité des états codants GKP,

- [Fig.10] représente les niveaux d'énergie des états de la figure 9,

- [Fig.11] représente une implémentation dite à rétroaction du circuit de la figure 2,

- [Fig.12] représente les déplacements de l'état du mode résonant cible GKP du circuit de la figure 11 par rétroaction,

- [Fig.13] représente une implémentation dite dissipative du circuit de la figure 2,

- [Fig.14] représente le profil temporel d'activation des jonctions Josephson de la figure 13,

- [Fig.15] représente les déplacements de l'état du mode résonant cible du circuit de la figure 11 par dissipation, et

- [Fig.16] est un exemple de mise en œuvre du circuit de la figure 13.

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

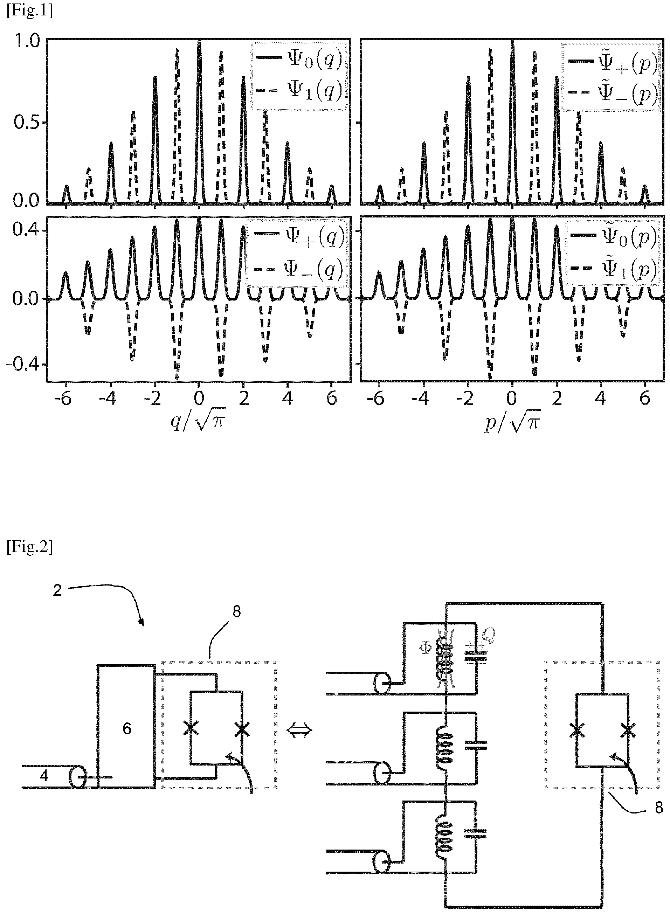

L'invention concerne la mise en œuvre de qubits logiques par le biais de codes GKP. Afin de mieux comprendre comment stabiliser ceux-ci, la figure 1 offre une représentation de des états codants « 0 » et « 1 » et de leurs superpositions symétrique et antisymétrique « + » et « - » d'un code GKP carré selon les quadratures q et p. Le code GKP permet de s'assurer que des états logiques orthogonaux ont des supports distants dans le plan de phase (q,p). En variante, la maille de la grille GKP peut être un parallélogramme, du moment que son aire dans le plan (q,p) aux coordonnées normalisées (telles que le commutateur [q,p]=i) vaut $4\pi$. Un cas particulier lorsque l'angle du parallélogramme vaut $\pi/3$ est connu comme « code hexagonal ».

Dans ce qui suit, les équations présentées sont en référence à des codes GKP idéalisés, dont les états s'étendent de manière infinie dans le plan de phase (« *infinitely squeezed states* » en anglais), ci-après « codes GKP de taille infinie ».. L'invention vise une implémentation avec des codes GKP « réalistes », c'est-à-dire dont les états ont un support de taille finie dans le plan de phase (« *finitely squeezed states* » en anglais), ci-après « codes GKP de taille finie ». Cette implémentation pourra impliquer des changements mineurs aux équations présentées ci-après, et les modifications dans le protocole de stabilisation seront précisés à chaque fois que possible plus bas.

Comme on peut le voir sur cette figure, les différents états codants sont séparés par $\sqrt{\pi}$ selon la quadrature q ou selon la quadrature p.

Sur cette figure, chaque cadran représente la distribution de probabilité pour certaines paires d'états orthogonaux en bit (0 ;1) ou en phase (+ ; -), selon la quadrature q ou la quadrature p. La distance entre les états 0 et 1 en q permet d'obtenir une protection contre les bit flips, tandis que la distance entre les états + et - en p permet d'obtenir une protection contre les phase flips. Les circuits selon l'invention permettent de générer et de stabiliser ces états par couplage effectif au mode cible via les opérateurs modulaires $e^{\pm 2i\sqrt{\pi}q}$ et $e^{\pm 2i\sqrt{\pi}p}$ qu'elle met en œuvre, où q et p sont les opérateurs de quadrature du mode cible dans le référentiel tournant à la fréquence du mode cible. Ces opérateurs modulaires sont les stabilisateurs du code GKP de taille infinie.

Dans une implémentation dite Hamiltonienne, l'invention lève la dégénérescence en énergie des états propres de ces stabilisateurs, et les états codants sont de plus basse énergie et donc stabilisés en présence de dissipation vers un réservoir de basse température effective.

Dans une implémentation dite de rétroaction par la mesure, ces stabilisateurs sont mesurés et le résultat de la mesure permet de stabiliser les états codants par rétroaction.

Dans une implémentation dite d'ingénierie de la dissipation, l'interaction entre le mode cible et des modes ancillaires à forte dissipation via les opérateurs modulaires du mode cible d'une part, et des opérateurs linéaires des modes ancillaires d'autre part, génère une dissipation effective modulaire stabilisant les états codants GKP.

Dans le cas des principales erreurs pour les résonateurs supraconducteurs, c'est-à-dire la dissipation à un seul photon, la Demanderesse estime que les qubits ainsi encodés peuvent avoir une vie de l'ordre de grandeur du dixième de seconde, tout en restant contrôlables par des portes tolérantes à l'erreur et d'une durée de l'ordre de la microseconde, ce qui représente une amélioration du rapport entre le temps de cohérence et le temps de porte de plusieurs ordres de grandeurs par rapport à tous les qubits implémentés jusqu'à présent.

La Demanderesse a découvert une classe de circuits quantiques qui permettent de mettre en œuvre les opérateurs modulaires mentionnés plus haut par la combinaison d'un élément à jonction Josephson à énergie réglable et d'une portion de circuit passive linéaire, en mettant en œuvre un réglage particulier de l'énergie de l'élément à jonction Josephson.

La figure 2 représente une vue générique d'un circuit quantique de ce type. Comme on peut le voir sur cette figure, le circuit 2 comprend une ligne de transmission 4 connectée à un terminal (ou « port » en anglais) relié à une portion de circuit passive linéaire 6, ainsi qu'un élément à jonction Josephson 8 relié aux bornes de la portion de circuit passive linéaire 6.

La ligne de transmission 4 pourra être réalisée de toute manière connue dans le domaine, sur puce ou hors-puce, 2D ou 3D, etc., selon toute géométrie connue pour une ligne de transmission microonde.

La portion de circuit passive 6 pourra être réalisée de toute manière connue permettant d'obtenir les décompositions de Foster évoquées plus bas lorsqu'elles transportent un signal dans la gamme microonde.

L'élément à jonction Josephson 8 présente une énergie de Josephson réglable. Comme représenté sur les figures 2, 7, 11 et 13, les circuits représentés permettent de régler l'énergie de Josephson par l'application d'un flux magnétique entre deux jonctions Josephson formant un SQUID (« *Superconducting Quantum Interference Device* » en anglais ou Dispositif d'interférence quantique supraconducteur), mais pourrait également être réglée par d'autres méthodes (circuits multi-jonctions plus complexes, jonction semiconductrice avec un biais en tension).

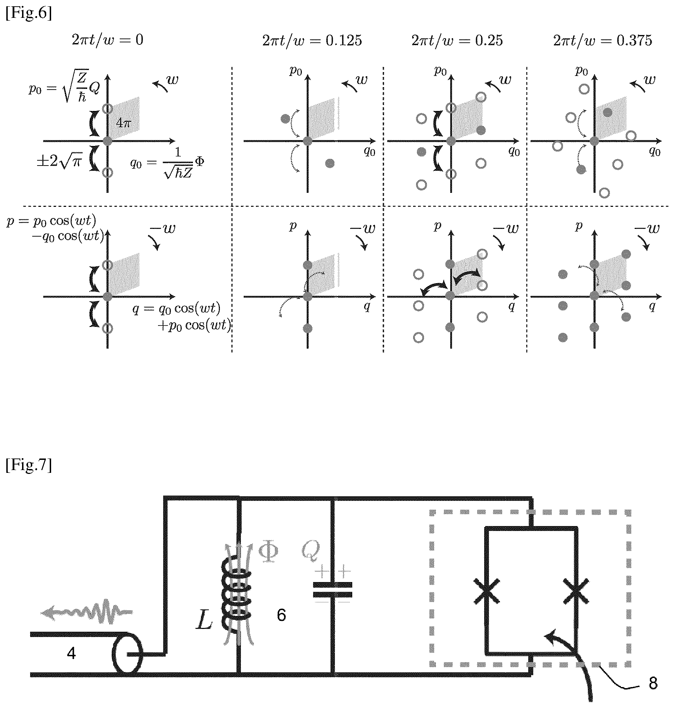

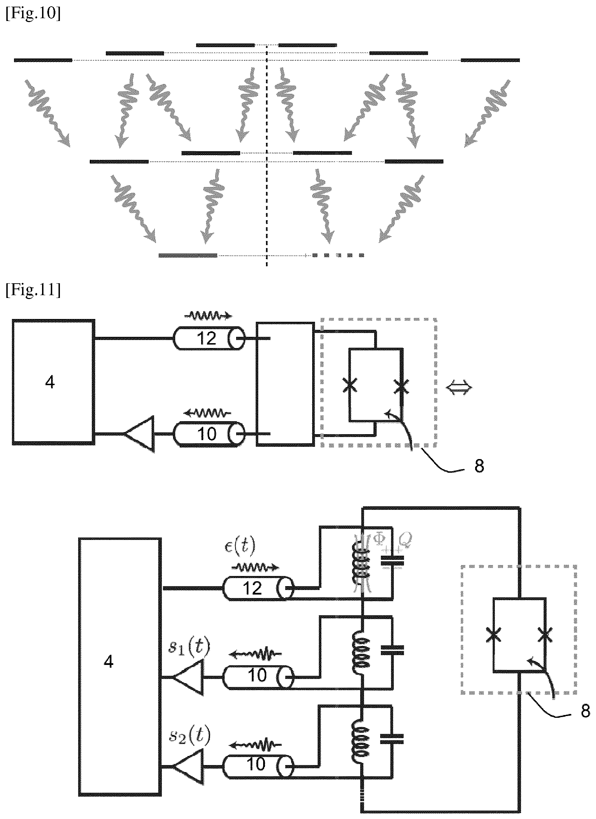

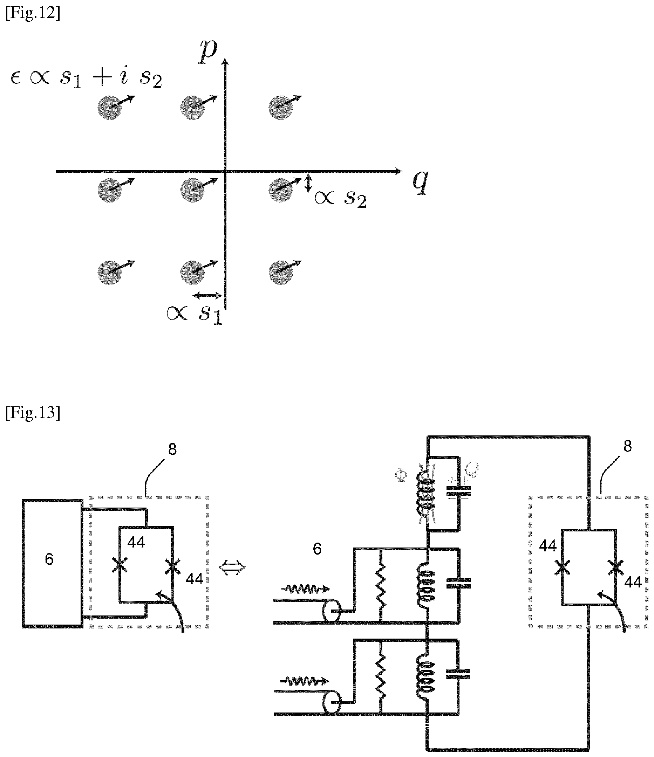

Selon les modes de réalisation, le circuit 2 pourra être modifié et agencé afin de permettre une stabilisation du code GKP dans une implémentation Hamiltonienne (figures 7 à 10), une implémentation à rétroaction (figures 11 et 12), ou une implémentation à dissipation (figures 13 à 16).

D'une manière générale, l'invention repose sur deux principes.

Le premier principe est que la portion de circuit passive linéaire 6 présente un ou plusieurs modes résonants dont la décomposition de Foster de première (voir par exemple l'article de Foster, R. M., "A reactance theorem", Bell System Technical Journal, vol.3, no. 2, pp. 259-267, November 1924) forme aux bornes de l'élément à jonction Josephson comprend un mode résonant présentant une impédance Z supérieure ou égale à 13 kOhms. Le circuit équivalent est représenté à droite sur la figure 2. Dans ce qui suit, ce mode résonant sera également appelé « mode cible ».

Cette valeur d'impédance est particulièrement importante car elle correspond au double du quantum de résistance (qui est défini par h/4e$^2$, soit 6,5k Ohms), ce qui permet à l'élément à jonction Josephson 8 de mettre en œuvre, dans le référentiel tournant du mode cible, à différents temps, deux opérateurs modulaires distincts et qui commutent, correspondant aux stabilisateurs du code GKP. En effet, la pulsation spatiale $\eta$ de l'opérateur modulaire est reliée à l'impédance présentée à l'élément Josephson via

$$\eta = \sqrt{2\,\pi\,Z\,/\,6{,}5\;kOhms}.$$

Le produit des pulsations des deux opérateurs modulaires vaut $4\pi$ dans le cas du code GKP carré, et est supérieur pour un code GKP non carré. La valeur de 13 kOhms est donc la valeur minimale pour stabiliser le code GKP. Avec des valeurs d'impédance au-delà de 19,5 kOhms, on pourrait par exemple stabiliser des qutrits.

Le deuxième principe est que le réglage de l'énergie de Josephson, représenté par la flèche qui pénètre l'élément à jonction Josephson 8 sur la figure 2, permet d'organiser les déplacements que les états du code GKP peuvent réaliser comme cela sera décrit ci-après.

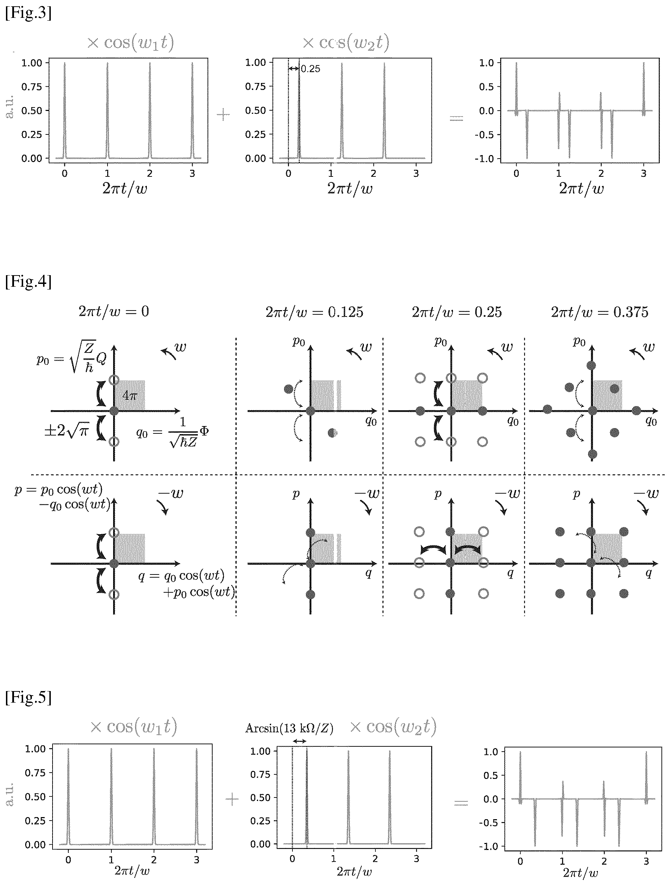

Ainsi, la figure 3 représente les signaux utilisés pour moduler l'énergie de Josephson. Ce réglage, à droite de la figure 3 est la résultante de la somme de deux sinusoïdes de pulsation respective w1 et w2 qui modulent chacune l'amplitude d'un train d'impulsions, lesquels trains sont décalés entre eux d'un quart de période associée à la pulsation du mode résonant dont l'impédance est égale à 13 kOhms. Chaque impulsion présente une largeur inférieure à un dixième de ce quart de période.

Une autre manière de décrire la figure 3 est que le signal de régulation de l'énergie Josephson de l'élément à jonction Josephson 8 est la somme de deux signaux de commande qui agissent pour « éteindre » ou « allumer » l'énergie Josephson de manière particulière à des instants choisis :

- Le premier signal de commande est tel que l'énergie de Josephson est activée à chaque période associée à la pulsation du mode résonant d'impédance supérieure ou égale à 13 kOhms, et sensiblement nulle aux autres instants, et cette énergie est modulée en amplitude par une sinusoïde de pulsation w1 égale à la pulsation d'un premier mode ancillaire de correction de l'opérateur conjugué q dans la décomposition de Foster,

- Le deuxième signal de commande est tel que l'énergie de Josephson résultante est activée à chaque période associée à la pulsation du mode résonant d'impédance supérieure ou égale à 13 kOhms, et sensiblement nulle aux autres instants, et cette énergie est modulée en amplitude par une sinusoïde de pulsation w2 à la pulsation d'un deuxième mode ancillaire de correction de l'opérateur conjugué p, et

- le premier signal de commande et le deuxième signal de commande sont décalés entre eux d'un quart de période associée à la pulsation w du mode résonant cible d'impédance égale à 13 kOhms.

En variante, les signaux de commande pourraient être activés à chaque demi-période au lieu de chaque période comme évoqué plus haut. Si nécessaire, cela peut être fait en inversant le signe de l'impulsion.

Le résultat de cette combinaison dans le cadre du code GKP mis en œuvre par le circuit 2 est représenté avec la figure 4.

La figure 4 représente les différents déplacements possibles sur la grille GKP en fonction des instants, dans le référentiel fixe d'axes q0 et p0 (en haut) ou dans un référentiel tournant d'axes q et p (en bas) à la pulsation w du mode cible. La notion de référentiel tournant est également appelée « représentation d'interaction », et les deux expressions pourront être interchangées dans la suite.

Dans le référentiel fixe, du fait de la résonance du mode de pulsation w, les états du résonateur vont tourner à la pulsation w, et des déplacements cohérents et discrets selon la maille de la grille GKP seront possibles tous les quarts de périodes si le mode cible est présenté à l'élément à jonction Josephson avec une impédance adaptée. Or, avec le profil d'activation de la figure 3, cela n'arrive que tous les quarts de période, selon un train d'impulsion ou l'autre. Cela signifie que lorsque $2\pi t/w$ vaut 0,125 ou 0,375, l'énergie Josephson est nulle, ce qui empêche tout déplacement hors de la grille. A l'inverse, tous les quarts de période, cela est possible, selon +q0, -q0, +p0 ou -p0. On peut aussi bien le comprendre avec la représentation dans le référentiel tournant, dans laquelle les états sont stables (puisque le référentiel tourne à la pulsation w), et ce sont les déplacements qui tournent (donc un déplacement est possible selon +q, -q, +p ou -p) et sont possibles tous les quarts de période.

Ainsi, le circuit de la figure 2 permet de générer et stabiliser un état de grille GKP puisque la dynamique du mode peut être cohérente et contrainte selon la grille GKP.

Dans le cas particulier des figures 3 et 4, le mode résonant de pulsation w présente une impédance égale à 13 kOhms, de sorte que les opérateurs q et p unitaires couvrent une aire égale à $4\pi$.

Il est néanmoins possible que le mode résonant de pulsation w présente une impédance supérieure à 13 kOhms. Dans ce cas, comme représenté sur les figures 5 et 6, il convient de décaler légèrement les trains d'impulsions entre eux, et la grille GKP est alors un losange dont l'aire reste égale à $4\pi$.

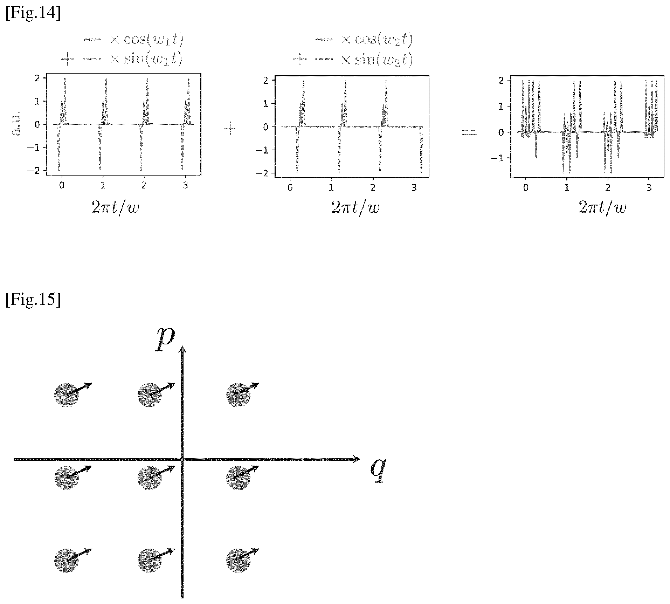

Les figures 7 à 15 représentent 3 modes de réalisation distincts qui permettent de stabiliser le qubit encodé dans le code GKP d'un tel circuit. Ainsi, les figures 7 à 10 décrivent un circuit quantique mettant en œuvre une stabilisation Hamiltonienne et un schéma de modulation de l'élément à jonction Josephson, les figures 11 et 12 décrivent un circuit quantique mettant en œuvre une stabilisation par rétroaction (« feedback » en anglais), et les figures 14 à 16 décrivent un circuit quantique mettant en œuvre une stabilisation par dissipation.

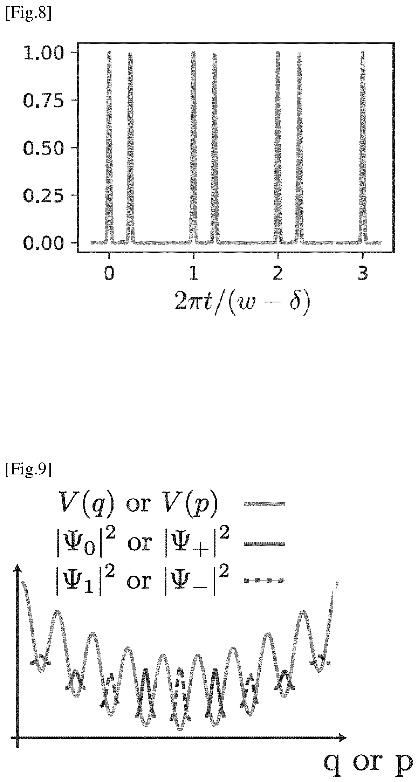

La figure 7 montre la décomposition de Foster de première forme d'une portion de circuit passive linéaire 6. Dans ce mode de réalisation, les pulsations w1 et w2 sont nulles, de sorte que le profil d'activation de l'énergie Josephson de l'élément à jonction Josephson 8 est représenté sur la figure 8, et induit des potentiels d'énergie représentés sur la figure 9 pour les modes p et q. Ainsi, les trains d'impulsion sont chacun modulés par une sinusoïde de pulsation nulle qui vaut donc toujours 1. Dit autrement, il est rappelé que la valeur 1 est une sinusoïde de pulsation nulle. En variante, les trains d'impulsions pourraient être doublés de manière symétrique par rapport à la période.

Dans le référentiel tournant, et en l'absence de dynamique Josephson, tous les états de l'oscillateur sont dégénérés et d'énergie nulle. La séquence d'impulsions dans cette implémentation Hamiltonienne génère un potentiel en boîte d'oeufs selon q et p qui lève la dégénérescence de ces niveaux d'énergie et assure que les états codants sont les états de plus basse énergie, leur densité de probabilité étant localisée au fond des puits de potentiel.

Cela a pour conséquence que les états codants GKP sont les états de plus basse énergie dans une représentation d'interaction abaissant la pulsation du mode cible à une pulsation inférieure à un tiers de l'énergie Josephson divisée par la constante de Planck réduite.

Dans ce mode de réalisation, afin de permettre de stabiliser le qubit, c'est-à-dire afin de ramener un état du code GKP excité vers un état codant, donc de basse énergie, le circuit comprend une ligne de transmission 4 qui couple le circuit 2 à un environnement dont le produit de la constante de Boltzmann par la température effective, dans la représentation d'interaction, est inférieur à l'énergie Josephson dans cette représentation.

De ce fait, les états d'énergie élevés ont tendance à se relaxer en perdant de l'énergie à travers la ligne de transmission 4 (comme représenté par la flèche sur la figure 7), de sorte qu'en cas d'excitation du résonateur, celui-ci revient naturellement vers son état codant de basse énergie comme cela apparaît sur la figure 10, dans laquelle les traits représentent les différents états de l'Hamiltonien GKP en fonction de leur niveau d'énergie.

Ce qui précède correspond à un code GKP de taille infinie. Dans le cas d'un code GKP de taille finie, la durée entre les impulsions au sein d'un train d'impulsions pourra être augmentée ou diminuée d'une quantité faible, typiquement inférieure à $\dfrac{4\pi^2 E}{5hw^2}$ où E est l'amplitude de la modulation du potentiel effectif (V(q) et V(p)), h est la constante de Planck.

Ce mode de réalisation est particulièrement avantageux lorsque les perturbations limitant la cohérence du qubit sont Hamiltoniennes.

La figure 11 représente un second mode de réalisation du circuit quantique 2 dans lequel le circuit 2 comprend en outre un organe de mesure 10 et un organe de rétroaction 12 disposés entre l'environnement 4 et la portion de circuit passive linéaire 6.

Les pulsations wi sont ici choisies pour correspondre à une pulsation d'un des modes résonants de la décomposition de Foster aux bornes de l'élément à jonction Josephson 8 de la portion de circuit passive linéaire 6 différente de la pulsation w du mode résonant dont l'impédance est supérieure ou égale à 13 kOhms, les pulsations wi étant distinctes entre elles.

L'organe de mesure 10 est linéaire homodyne des modes résonants correspondants aux pulsations wi respectives, agencé pour mesurer les déplacements des modes résonants de pulsation wi selon une direction de leur plan de phase respectif déterminée par la phase de la porteuse sinusoïdale de pulsation wi, et permet de mesurer les opérateurs modulaires, c'est à dire mesurer les syndromes d'erreur GKP, sans risque de propagation d'erreur, à savoir que la décohérence ou dissipation affectant le mode ancillaire ne risque pas d'induire d'erreur logique sur le qubit GKP. L'organe de mesure 10 peut par exemple être implémenté par un amplificateur paramétrique à jonctions Josephson fonctionnant proche de la limite quantique.

L'organe de rétroaction 12 est agencé pour déplacer l'état du mode résonant présentant une impédance Z supérieure à 13 kOhms selon une direction de son plan de phase déterminée par la phase du train d'impulsions correspondant à la pulsation wi par à la référence de phase dudit mode résonant présentant une impédance Z supérieure à 13 kOhms, de manière proportionnée à une mesure reçue de l'organe de mesure 10. L'organe de rétroaction 12 peut être mis en œuvre par l'application d'une microonde à la pulsation w dont la phase et l'amplitude sont proportionnelles au résultat de la mesure.

Ainsi, comme cela apparaît sur a figure 12, les états GKP sont déplacés par l'organe de rétroaction 12 selon un vecteur du plan de phase dont les coordonnées sont proportionnelles aux syndromes d'erreur s1 et s2 mesurés par l'organe de mesure 10. Le circuit 2 peut également être agencé pour avoir plus de deux syndromes de mesure d'erreur.

Cette description correspond à une implémentation pour un code GKP de taille infinie. Dans le cas d'un code GKP de taille finie, il serait possible d'alterner la mesure des opérateurs modulaires avec une rétroaction linéaire (telle que décrit plus haut), avec une mesure linéaire (homodyne) faible avec une rétroaction modulaire faible.

En variante, la Demanderesse a découvert que les trains d'impulsions peuvent être activés l'un après l'autre en étant modulés par la même porteuse sinusoïdale de pulsation wi, de sorte qu'un train d'impulsions se terminent avant l'activation du train suivant, chaque train comprenant un nombre d'impulsion compris entre 10 et 10^8.

La Demanderesse a également découvert un troisième mode de réalisation dans lequel la stabilisation est réalisée par dissipation.

En effet, la stabilisation peut être rendue autonome avec une dissipation simple sur des modes ancillaires. On obtient alors une dissipation doublement modulaire du résonateur cible. Plus précisément, le circuit 2 de la figure 13 permet de stabiliser le qubit logique GKP par le biais d'opérateurs modulaires de manière dissipative.

Dans le mode de réalisation de la figure 13, l'élément à jonction Josephson 8 comprend deux jonctions Josephson 44 en parallèle l'une de l'autre, et son profil d'énergie est modulé avec des porteuses sinusoïdales dont les pulsations wi sont choisies de manière similaire à celle du mode de réalisation des figures 11 et 12.

La portion de circuit passive linéaire 6 est en outre agencée de sorte que les modes résonants de pulsation wi dissipent leurs excitations respectives dans un environnement dont le produit de la température par la constante de Boltzmann est inférieure au produit de la pulsation wi par la constante de Planck réduite et selon un taux supérieur à $\sqrt{w/4 * Z_i/(6,5\ kOhms))} * e_i$ où $Z_i$ est l'impédance du mode de pulsation wi aux bornes de l'éléments dudit élément à jonction Josephson et $e_i$ est l'énergie Josephson moyenne intégrée sur la durée d'une impulsion.

Comme représenté sur la figure 14, pour l'implémentation adaptée à un code GKP de taille finie, chaque impulsion est précédée d'une pré-impulsion et est suivie d'une post-impulsion, la pré-impulsion et la post-impulsion (en traits tiretés) étant modulées par une porteuse sinusoïdale en quadrature avec la porteuse de l'impulsion et étant décalée par rapport à l'impulsion d'une durée respective δ inférieure à 1/(5w) et présentant une amplitude opposée et de valeur absolue inférieure à 1/(3δw).

De manière préférée, l'élément à jonction Josephson 8 est couplé à quatre modes dissipatifs ancillaires afin de réaliser une dynamique de Lindblad à quatre dissipateurs. Il serait néanmoins possible de réaliser une dynamique de Lindblad à deux dissipateurs, voire à six dissipateurs.

En variante, la Demanderesse a découvert que les trains d'impulsions peuvent être activés l'un après l'autre en étant modulés par la même porteuse sinusoïdale de pulsation wi, de sorte qu'un train d'impulsions se terminent avant l'activation du train suivant, chaque train comprenant un nombre d'impulsion compris entre 10 et 10^8.

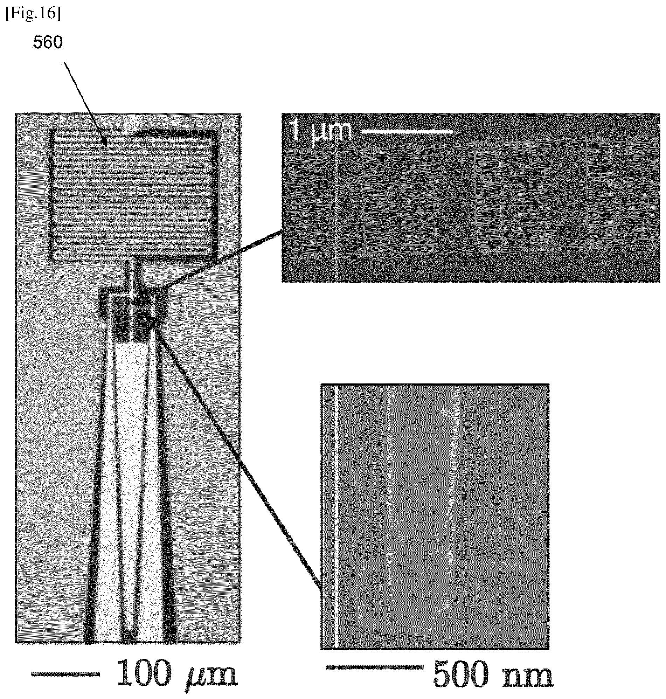

La figure 16 représente une photographie vue de dessus d'une mise en œuvre réelle d'un circuit selon la figure 13. Cette photographie a été obtenue par microscopie optique (photographie de gauche) et par microscopie électronique à balayage (photographie de droite).

Cette figure comprend plusieurs agrandissements permettant de mieux voir la réalisation des différents éléments. Ainsi, on peut voir une inductance 560 réalisée par une longue piste utilisée pour ajuster l'impédance des modes ancillaires présentée à l'élément à jonction Josephson, ainsi que les pistes pour les signaux de commande. Ces agrandissements permettent également de mieux apprécier les ordres de grandeur, les jonctions Josephson ayant une dimension de l'ordre de 500 nm, l'ATS une dimension de l'ordre de 100 μm, et les pistes pour les signaux de commande une dimension de l'ordre du millimètre.

Le circuit de la figure 13 peut être mis en œuvre au moyen d'un circuit ATS (Asymmetrically Threaded SQUID). Le circuit ATS comprend un SQUID symétrique qui est court-circuité en son centre par une grande inductance, ce qui forme deux boucles.

Ainsi l'ATS implémente un oscillateur LC additionné d'une énergie Josephson d'amplitude et de phase contrôlables. Le mode commun de l'anneau du circuit ATS peut avoir une impédance Z égale à 13 kOhms et une fréquence de résonance dans la gamme RF pour une inductance suffisamment grande dans le bras central du circuit. Des modes distribués de basse impédance, de symétrie adaptée, et connectés à l'anneau, peuvent servir de modes ancillaires. Dans la représentation de Foster de première forme, les capacités ont des valeurs de l'ordre de 10 fF, et les inductances ont une valeur de l'ordre de 1 à 10 μH.

Utiliser un ATS en place d'un SQUID est avantageux dans le cas d'une dynamique de Lindblad à quatre dissipateurs. En effet, le contrôle de la phase de chaque opérateur modulaire mis en œuvre grâce à l'élément à jonction Josephson est important dans ce cas, deux des dissipateurs étant associés à un cosinus, et les deux autres étant associés à un sinus.

Ce mode de réalisation est particulièrement avantageux car le circuit ATS a été mis en œuvre de manière pratique par la Demanderesse, qui maîtrise particulièrement bien sa fabrication.

Avantageusement, l'impédance du mode cible telle que présentée à l'élément à jonction Josephson 8 peut être ajustée, ce qui permet de réaliser un ensemble universel de portes de Clifford. Cet ajustement peut être réalisé en introduisant un coupleur ajustable entre la portion de circuit passive linéaire 6 et l'élément à jonction Josephson 8. Ce coupleur ajustable peut être réalisé de manière connue par l'homme du métier, par exemple dans le contexte des circuits supraconducteurs (« *circuit QED* » en anglais).

Ainsi, selon une première variante, l'impédance du mode résonant cible est égale à 13 kOhms, ce qui fixe un code GKP carré. Dans ce cas, en variant légèrement la durée entre deux impulsions au sein de chaque train, il est possible de faire pivoter progressivement la grille d'états GKP jusqu'à obtenir une rotation d'angle $\pi/2$. On obtient ainsi une porte de Hadamard.

Dans une autre variante, l'impédance du mode résonant cible est égale à 15 kOhms ce qui fixe un code GKP hexagonal. Dans ce cas, en variant légèrement la durée entre deux impulsions au sein de chaque train, il est possible de faire pivoter progressivement la grille d'états GKP jusqu'à obtenir une rotation d'angle de $\pi/3$ de la grille d'états GKP. On obtient ainsi une porte de permutation circulaire des trois axes de la sphère de Bloch du qubit logique (X=>Y=>Z=>X...).

Lorsque deux circuits présentent une impédance ajustable et que leurs portions de circuit passive linéaire 6 sont respectivement reliées à l'élément à jonction Josephson 8 de l'autre circuit par un coupleur ajustable, il devient possible de mettre en œuvre une porte CNOT.

Dans encore une autre variante, l'impédance ajustable peut être utilisée pour réaliser un circuit d'initialisation protégée ou de lecture protégée du qubit logique. Dans ce cas, le circuit supraconducteur quantique à gamme microonde comprend deux éléments à jonction Josephson 8. Au moins un élément à jonction Josephson 8 est relié à la portion de circuit passive linéaire 6 de telle sorte que l'impédance du mode cible qui lui est présentée est ajustable. L'aire de la maille du code GKP est alors réduite d'un facteur 2, et l'énergie de chaque élément à jonction Josephson est réglée en fonction de l'impédance du mode cible qui lui est présentée. Avantageusement, pour un code GKP carré, l'un des modes cibles aura une impédance de 13 kOhms, tandis que l'autre autre une impédance de 6,5 kOhms.

## Revendications

1. Circuit supraconducteur quantique à gamme microonde comprenant un élément à jonction Josephson (8) à énergie réglable relié à une portion de circuit passive linéaire (6) présentant plusieurs modes résonants dont la décomposition de Foster de première forme aux bornes de l'élément à jonction Josephson (8) comprend un mode résonant cible présentant une impédance Z supérieure ou égale à 13 kOhms et une pulsation w, l'énergie dudit élément à jonction Josephson (8) étant réglable et modulée par au moins deux trains d'impulsions respectifs au sein desquels les impulsions sont séparées par une durée $2\pi/w$ et présentent une largeur inférieure à un dixième de cette durée, l'amplitude des impulsions au sein de chaque train d'impulsions respectif étant modulée par une porteuse sinusoïdale respective et les trains d'impulsions étant décalés deux à deux respectivement d'une durée $\Delta t$ telle que $|\sin(w*\Delta t)|$ vaut 13 kOhms/Z, de sorte que le mode résonant cible se stabilise dans un de deux états GKP encodant un qubit.

2. Circuit supraconducteur quantique à gamme microonde selon la revendication 1, dans lequel la pulsation wi de la porteuse sinusoïdale de chaque train d'impulsions respectif est nulle, de sorte que les états codants GKP sont les états de plus basse énergie dans une représentation d'interaction abaissant la pulsation du mode résonant cible à une pulsation inférieure à un cinquième de l'amplitude du potentiel effectif modulaire généré pour le mode résonant cible divisée par la constante de Planck réduite, lesdits états de plus basse énergie étant stabilisés par couplage à un environnement (4) dont le produit de la constante de Boltzmann par la température effective est inférieure à l'énergie Josephson dans cette représentation.

3. Circuit supraconducteur quantique à gamme microonde selon la revendication 1, dans lequel pulsation wi de la porteuse sinusoïdale de chaque train d'impulsions respectif est une pulsation d'un des modes résonants de la décomposition de Foster aux bornes de l'élément à jonction Josephson (8) de la portion de circuit passive linéaire (6) différente de la pulsation w, le circuit supraconducteur quantique à gamme microonde comprenant en outre un organe de mesure (10) linéaire homodyne des modes résonants correspondants aux pulsations wi respectives, agencé pour mesurer les déplacements des modes résonants de pulsation wi selon une direction de leur plan de phase respectif déterminée par la phase de la porteuse sinusoïdale de pulsation wi, et un organe de rétroaction (12) agencé pour déplacer l'état du mode résonant cible selon une direction de son plan de phase déterminée par la phase du train d'impulsions correspondant à la pulsation wi par rapport à la référence de phase dudit mode résonant cible, de manière proportionnée à une mesure reçue de l'organe de mesure (10).

4. Circuit supraconducteur quantique à gamme microonde selon la revendication 1, dans lequel pulsation wi de la porteuse de chaque train d'impulsions respectif est une pulsation d'un des modes résonants de la décomposition de Foster de la première forme aux bornes de l'élément à jonction Josephson (8) de la portion de circuit passive linéaire (6) différente de la pulsation w, la portion de circuit passive linéaire (6) étant agencée de sorte que lesdits modes résonants de pulsation wi dissipent leurs excitations respectives dans un environnement dont le produit de la température par la constante de Boltzmann est inférieure au produit de la pulsation wi par la constante de Planck réduite et selon un taux supérieur à

$$\sqrt{\frac{w}{4} * \frac{Z_i}{6,5 \, kOhms}} * e_i$$

où $Z_i$ est l'impédance du mode de pulsation wi aux bornes de l'éléments dudit élément à jonction Josephson et $e_i$ est l'énergie Josephson moyenne intégrée sur la durée d'une impulsion, chaque impulsion étant précédée d'une pré-impulsion et suivie d'une post-impulsion, la pré-impulsion et la post-impulsion étant modulées par une porteuse sinusoïdale en quadrature avec la porteuse de l'impulsion et étant décalée par rapport à l'impulsion d'une durée respective $\delta$ inférieure à $1/(5w)$ et présentant une amplitude opposée et de valeur absolue inférieure à $1/(3\delta w)$.

5. Circuit supraconducteur quantique à gamme micro-onde selon l'une des revendications 1 à 4, dans lequel les trains d'impulsions respectifs sont activés dans des fenêtres temporelles se chevauchant, et dans lequel les pulsations des porteuses sinusoïdales qui modulent leurs amplitudes respectives sont distinctes.

6. Circuit supraconducteur quantique à gamme micro-onde selon l'une des revendications 1 à 4, dans lequel les trains d'impulsions respectifs sont activés l'un après l'autre et sont modulés par la même porteuse sinusoïdale de pulsation wi, de sorte qu'un train d'impulsions se terminent avant l'activation du train suivant, chaque train comprenant un nombre d'impulsion compris entre 10 et 10^8.

7. Circuit supraconducteur quantique à gamme micro-onde selon l'une des revendications précédentes, dans lequel l'élément à jonction Josephson présente une phase réglable permettant de modifier la position de la grille d'états GKP.

8. Circuit supraconducteur quantique à gamme micro-onde l'une des revendications précédentes, dans lequel l'impédance du mode résonant cible est ajustable, et dans lequel le décalage entre les trains d'impulsions respectifs peut être adapté pour permettre de modifier la forme de la maille de la grille d'états GKP.

9. Circuit supraconducteur quantique à gamme micro-onde selon la revendication 8 dans lequel l'impédance du mode résonant cible est égale à 13 kOhms, dans lequel la pulsation du mode résonant cible est modifiée afin de réaliser une rotation de $\pi/2$ de la grille d'états GKP, et dans lequel la durée entre les impulsions au sein d'un même train est modifiée de manière adaptée à cette pulsation modifiée.

10. Circuit supraconducteur quantique à gamme micro-onde selon la revendication 8 dans lequel l'impédance du mode résonant cible est égale à 15 kOhms, dans lequel la pulsation du mode résonant cible est modifiée afin de réaliser une rotation de $\pi/3$ de la grille d'états GKP, et dans lequel la durée entre les impulsions au sein d'un même train est modifiée de manière adaptée à cette pulsation modifiée.

11. Circuit supraconducteur quantique à gamme micro-onde selon la revendication 8 comprenant deux éléments à jonction Josephson à énergie réglable, chacun relié à ladite portion de circuit passive linéaire (6) de telle sorte que l'impédance du mode résonant cible présentée à au moins un des deux éléments à jonction Josephson est ajustable, l'énergie de chaque élément à jonction Josephson (8) étant réglable et modulée en fonction de chaque impédance respective du mode résonant cible.

12. Circuit supraconducteur quantique à gamme micro-onde, comprenant deux circuits dont l'un au moins est selon l'une des revendications 8 ou 11 reliés entre eux de manière à définir une porte logique.

13. Circuit supraconducteur quantique à gamme micro-onde selon la revendication 12, dans lequel lesdits deux circuits sont selon la revendication 8, la portion de circuit passive linéaire (6) de chaque circuit étant reliée à l'élément à jonction Josephson (8) de l'autre circuit par un coupleur ajustable de manière à régler l'impédance du mode résonant cible de chaque circuit présentée à l'élément à jonction Josephson de l'autre circuit.

**Patentansprüche**

1. Supraleitende Quantenschaltung im Mikrowellenbereich, umfassend ein Josephson-Übergang-Element (8) mit regelbarer Energie, das mit einem linearen passiven Schaltungsabschnitt (6) verbunden ist, der mehrere Resonanzmoden aufweist, wobei die Foster-Zerlegung erster Form an den Anschlüssen des Josephson-Übergang-Elements (8) eine Ziel-Resonanzmode aufweist, die eine Impedanz Z größer oder gleich 13 kOhm und eine Kreisfrequenz w aufweist, wobei die Energie des Josephson-Übergang-Elements (8) regelbar ist und durch mindestens zwei jeweilige Impulsfolgen moduliert wird, in denen die Impulse durch eine Dauer $2\pi/w$ getrennt sind und eine Breite von weniger als einem Zehntel dieser Dauer aufweisen, wobei die Amplitude der Impulse in jeder jeweiligen Impulsfolge durch einen jeweiligen sinusförmigen Träger moduliert wird und die Impulsfolgen paarweise jeweils um eine Dauer $\Delta t$

versetzt sind, so dass |sin(W*Δt)| 13 kOhm/Z beträgt, so dass sich die Ziel-Resonanzmode in einem von zwei GKP-Zuständen stabilisiert, die ein Qbit kodieren.

2. Supraleitende Quantenschaltung im Mikrowellenbereich nach Anspruch 1, wobei die Kreisfrequenz wi des sinusförmigen Trägers jeder jeweiligen Impulsfolge null ist, so dass die kodierenden GKP-Zustände die niederenergetischsten Zustände in einer Interaktionsdarstellung sind, in der die Kreisfrequenz der Ziel-Resonanzmode auf eine Kreisfrequenz von weniger als einem Fünftel der Amplitude des für die Ziel-Resonanzmode erzeugten effektiven modularen Potentials dividiert durch die reduzierte Planck-Konstante abgesenkt ist, wobei die niederenergetischsten Zustände durch Kopplung an eine Umgebung (4) stabilisiert werden, bei der das Produkt aus der Boltzmann-Konstante und der effektiven Temperatur kleiner als die Josephson-Energie in dieser Darstellung ist.

3. Supraleitende Quantenschaltung im Mikrowellenbereich nach Anspruch 1, wobei die Kreisfrequenz wi des sinusförmigen Trägers jeder jeweiligen Impulsfolge eine Kreisfrequenz einer der Resonanzmoden der Foster-Zerlegung an den Anschlüssen des Josephson-Übergang-Elements (8) des linearen passiven Schaltungsabschnitts (6) ist, die von der Kreisfrequenz w verschieden ist, wobei die supraleitende Quantenschaltung im Mikrowellenbereich ferner ein lineares homodynes Messorgan (10) zur Messung der den jeweiligen Kreisfrequenzen wi entsprechenden Resonanzmoden umfasst, das dazu eingerichtet ist, die Verschiebungen der Resonanzmoden mit der Kreisfrequenz wi entlang einer Richtung ihrer jeweiligen Phasenebene zu messen, die durch die Phase des sinusförmigen Trägers mit der Kreisfrequenz wi bestimmt wird, und ein Rückkopplungsorgan (12), das dazu eingerichtet ist, den Zustand der Ziel-Resonanzmode entlang einer Richtung ihrer Phasenebene, die durch die der Kreisfrequenz wi entsprechenden Impulsfolge im Verhältnis zur Phasenreferenz der Ziel-Resonanzmode bestimmt wird, proportional zu einer von dem Messorgan (10) empfangenen Messung zu verschieben.

4. Supraleitende Quantenschaltung im Mikrowellenbereich nach Anspruch 1, wobei die Kreisfrequenz wi des Trägers jeder jeweiligen Impulsfolge eine Kreisfrequenz einer der Resonanzmoden der Foster-Zerlegung erster Form an den Anschlüssen des Josephson-Übergang-Elements (8) des linearen passiven Schaltungsabschnitts (6) ist, die von der Kreisfrequenz w verschieden ist, wobei der lineare passive Schaltungsabschnitt (6) so eingerichtet ist, dass die Resonanzmoden mit der Kreisfrequenz wi ihre jeweiligen Anregungen in eine Umgebung dissipieren, bei der das Produkt aus der Temperatur und der Boltzmann-Konstante kleiner als das Produkt aus der Kreisfrequenz wi und der reduzierten Planck-Konstante ist, und gemäß einer Rate größer als

$$\sqrt{\frac{w}{4} * \frac{Z_i}{6{,}5\,kOhm}} * e_i$$ , wobei $Z_i$ die Impedanz

der Mode mit der Kreisfrequenz wi an den Anschlüssen des Elements des Josephson-Übergang-Elements ist und $e_i$ die über die Dauer eines Impulses integrierte mittlere Josephson-Energie ist, wobei jedem Impuls ein Vorimpuls vorausgeht und ein Nachimpuls folgt, wobei der Vorimpuls und der Nachimpuls durch einen sinusförmigen Träger in Quadratur mit dem Träger des Impulses moduliert werden und in Bezug auf den Impuls um eine jeweilige Dauer δ von weniger als 1/(5w) versetzt sind und eine entgegengesetzte Amplitude mit einem absoluten Wert von weniger als 1/(3δw) aufweisen.

5. Supraleitende Quantenschaltung im Mikrowellenbereich nach einem der Ansprüche 1 bis 4, wobei die jeweiligen Impulsfolgen in sich überlappenden Zeitfenstern aktiviert werden und wobei die Kreisfrequenzen der sinusförmigen Träger, die ihre jeweiligen Amplituden modulieren, verschieden sind.

6. Supraleitende Quantenschaltung im Mikrowellenbereich nach einem der Ansprüche 1 bis 4, wobei die jeweiligen Impulsfolgen nacheinander aktiviert werden und durch denselben sinusförmigen Träger mit der Kreisfrequenz wi moduliert werden, so dass eine Impulsfolge vor der Aktivierung der nächsten Folge endet, wobei jede Folge eine Anzahl von Impulsen zwischen 10 und 10^8 umfasst.

7. Supraleitende Quantenschaltung im Mikrowellenbereich nach einem der vorhergehenden Ansprüche, wobei das Josephson-Übergang-Element eine regelbare Phase aufweist, die es ermöglicht, die Position des Gitters aus GKP-Zuständen zu ändern.

8. Supraleitende Quantenschaltung im Mikrowellenbereich nach einem der vorhergehenden Ansprüche, wobei die Impedanz der Ziel-Resonanzmode anpassbar ist und wobei der Versatz zwischen den jeweiligen Impulsfolgen angepasst werden kann, um es zu ermöglichen, die Form der Masche des Gitters aus GKP-Zuständen zu ändern.

9. Supraleitende Quantenschaltung im Mikrowellenbereich nach Anspruch 8, wobei die Impedanz der Ziel-Resonanzmode 13 kOhm beträgt, wobei die Kreisfrequenz der Ziel-Resonanzmode geändert wird, um eine Rotation um π/2 des Gitters aus GKP-Zuständen zu realisieren, und wobei die Dauer zwischen den Impulsen in einer selben Folge auf eine Weise geändert wird, die an diese geänderte Kreisfrequenz angepasst ist.

10. Supraleitende Quantenschaltung im Mikrowellenbereich nach Anspruch 8, wobei die Impedanz der Ziel-Resonanzmode 15 kOhm beträgt, wobei die Kreisfrequenz der Ziel-Resonanzmode geändert wird, um eine Rotation um π/3 des Gitters aus GKP-Zuständen zu realisieren, und wobei die Dauer zwischen den Impulsen in einer selben Folge auf eine Weise geändert wird, die an diese geänderte Kreisfrequenz angepasst ist.

11. Supraleitende Quantenschaltung im Mikrowellenbereich nach Anspruch 8, umfassend zwei Josephson-Übergang-Elemente mit regelbarer Energie, von denen jeder mit dem linearen passiven Schaltungsabschnitt (6) so verbunden ist, dass die Impedanz der Ziel-Resonanzmode, die an mindestens einem der beiden Josephson-Übergang-Elemente anliegt, anpassbar ist, wobei die Energie jedes Josephson-Übergang-Elements (8) regelbar ist und in Abhängigkeit von jeder jeweiligen Impedanz der Ziel-Resonanzmode moduliert wird.

12. Supraleitende Quantenschaltung im Mikrowellenbereich, umfassend zwei Schaltungen, von denen mindestens eine einem der Ansprüche 8 oder 11 entspricht, die untereinander so verbunden sind, dass sie ein Logikgatter definieren.

13. Supraleitende Quantenschaltung im Mikrowellenbereich nach Anspruch 12, wobei die beiden Schaltungen Anspruch 8 entsprechen, wobei der lineare passive Schaltungsabschnitt (6) jeder Schaltung mit dem Josephson-Übergang-Element (8) der anderen Schaltung durch einen anpassbaren Koppler verbunden ist, so dass die Impedanz der Ziel-Resonanzmode jeder Schaltung, die an dem Josephson-Übergang-Element der anderen Schaltung anliegt, geregelt wird.

**Claims**

1. Superconducting microwave quantum circuit comprising a controllable-energy Josephson junction element (8) connected to a linear passive circuit portion (6) exhibiting a plurality of resonant modes, of which the Foster's first-form decomposition across the terminals of the Josephson junction element (8) comprises a target resonant mode exhibiting an impedance Z higher than 13 kohm and a pulsation w, the energy of said Josephson junction element (8) being controllable and modulated by at least two respective pulse trains within which the pulses are separated by a duration 2π/w and have a width of less than one tenth of said duration, the amplitude of the pulses within each respective pulse train being modulated by a respective sinusoidal carrier and the pulse trains being respectively offset pairwise by a duration Δt such that |sin(w*Δt)| equals 13 kohm/Z, so that the resonant mode of pulsation w is stabilised in one of two GKP states encoding a qubit.

2. Superconducting microwave quantum circuit according to claim 1, wherein the pulsation wi of the sinusoidal carrier of each respective pulse train is zero, so that the GKP coding states are the lowest energy states in an interaction representation lowering the pulsation of the target resonant mode to a pulsation lower than a fifth of the amplitude of the effective modular potential generated for the target resonant mode divided by the reduced Planck constant, said lowest energy states being stabilised by coupling with an environment (4) of which the product of the Boltzmann constant by the effective temperature is lower than the Josephson energy in this representation.

3. Superconducting microwave quantum circuit according to claim 1, wherein the pulsation wi of the sinusoidal carrier of each respective pulse train is a pulsation of a resonant mode of the Foster's decomposition across the terminals of the Josephson junction element (8) of the linear passive circuit portion (6) different from the pulsation w, the superconducting microwave quantum circuit further comprising a homodyne linear measurement member (10) of the resonant modes corresponding to the respective pulsations wi, arranged to measure the displacements of the resonant modes of pulsation wi in a direction of their respective phase plane determined by the phase of the sinusoidal carrier of pulsation wi, and a feedback member (12) arranged to displace the state of the target resonant mode in a direction of its phase plane determined by the phase of the pulse train corresponding to the pulsation wi in relation to the phase reference of said target resonant mode, proportionally to a measurement received from the measurement member (10).

4. Superconducting microwave quantum circuit according to claim 1, wherein the pulsation wi of the carrier of each respective pulse train is a pulsation of one of the resonant modes of the Foster's first-form decomposition across the terminals of the Josephson junction element (8) of the linear passive circuit portion (6) different from the pulsation w, the linear passive circuit portion (6) being arranged so that said resonant modes of pulsation wi dissipate their respective excitations into an environment of which the product of the temperature by the Boltzmann constant is lower than the product of the pulsation wi by the reduced Planck constant and according to a rate higher than $\sqrt{\frac{w}{4} * \frac{Z_i}{6.5 \, kohm}} * e_i$ where $Z_i$ is the impedance of the mode of pulsation $w_i$ across the terminals of the elements of said Josephson junction element and $e_i$ is the average Josephson energy integrated over the duration of a pulse, each pulse being preceded by a pre-pulse and followed by a post-pulse, the pre-pulse and the post-pulse being modulated by a quadrature sinusoidal carrier with the carrier of the pulse and being offset in relation to the pulse of a respective duration $\delta$ lower than $1/(5w)$ and having an opposite amplitude and of absolute value lower than $1/(3\delta w)$.

5. Superconducting microwave quantum circuit according to one of claims 1 to 4, wherein the respective pulse trains are activated in time windows that overlap, and wherein the pulsations of the sinusoidal carriers that modulate their respective amplitudes are distinct.

6. Superconducting microwave quantum circuit according to one of claims 1 to 4, wherein the respective pulse trains are activated one after another and are modulated by the same sinusoidal carrier of pulsation $w_i$, so that a pulse train ends before the activation of the following train, each train comprising a number of pulses between 10 and $10^8$.

7. Superconducting microwave quantum circuit according to one of the preceding claims, wherein the Josephson junction element has a controllable phase making it possible to modify the position of the GKP state grid.

8. Superconducting microwave quantum circuit according to one of the preceding claims, wherein the impedance of the target resonant mode is adjustable, and wherein the offset between the respective pulse trains may be adapted to make it possible to modify the shape of the mesh of the GKP state grid.

9. Superconducting microwave quantum circuit according to claim 8 wherein the impedance of the target resonant mode is equal to 13 kohm, wherein the pulsation of the target resonant mode is modified in order to perform a rotation of $\pi/2$ of the GKP state grid, and wherein the duration between the pulses within the same train is modified in a manner adapted to this modified pulsation.

10. Superconducting microwave quantum circuit according to claim 8 wherein the impedance of the target resonant mode is equal to 15 kohm, wherein the pulsation of the target resonant mode is modified in order to perform a rotation of $\pi/3$ of the GKP state grid, and wherein the duration between the pulses within the same train is modified in a manner adapted to this modified pulsation.

11. Superconducting microwave quantum circuit according to claim 8 comprising two controllable-energy Josephson junction elements, each connected to said linear passive circuit portion (6) such that the impedance of the target resonant mode exhibited at at least one of two Josephson junction elements is adjustable, the energy of each Josephson junction element (8) being controllable and modulated depending on each respective impedance of the target resonant mode.

12. Superconducting microwave quantum circuit, comprising two circuits of which one at least is according to one of claims 8 or 11 interconnected so as to define a logic gate.

13. Superconducting microwave quantum circuit according to claim 12, wherein said two circuits are according to claim 8, the linear passive circuit portion (6) of each circuit being connected to the Josephson junction element (8) of the other circuit by an adjustable coupler so as to control the impedance of the target resonant mode of each circuit exhibited at the Josephson junction element of the other circuit.

[Fig.1]

[Fig.2]

[Fig.3]

$\times \cos(w_1 t)$     $\times \cos(w_2 t)$

[Fig.4]

$2\pi t/w = 0$    $2\pi t/w = 0.125$    $2\pi t/w = 0.25$    $2\pi t/w = 0.375$

$$p_0 = \sqrt{\frac{Z}{\hbar}}Q$$

$$q_0 = \frac{1}{\sqrt{\hbar Z}}\Phi$$

$$p = p_0 \cos(wt) - q_0 \cos(wt)$$

$$q = q_0 \cos(wt) + p_0 \cos(wt)$$

[Fig.5]

$\times \cos(w_1 t)$     Arcsin(13 kΩ/Z)   $\times \cos(w_2 t)$

[Fig.6]

$2\pi t/w = 0$        $2\pi t/w = 0.125$        $2\pi t/w = 0.25$        $2\pi t/w = 0.375$

$p_0 = \sqrt{\dfrac{Z}{\hbar}}Q$

$4\pi$

$\pm 2\sqrt{\pi}$    $q_0 = \dfrac{1}{\sqrt{\hbar Z}}\Phi$

$p = p_0\cos(wt)$
$-q_0\cos(wt)$

$q = q_0\cos(wt)$
$+p_0\cos(wt)$

[Fig.7]

[Fig.8]

$$2\pi t/(w-\delta)$$

[Fig.9]

$V(q)$ or $V(p)$ ——
$|\Psi_0|^2$ or $|\Psi_+|^2$ ——
$|\Psi_1|^2$ or $|\Psi_-|^2$ ----

q or p

[Fig.10]

[Fig.11]

[Fig.12]

$$\epsilon \propto s_1 + i \, s_2$$

$p$

$q$

$\propto s_2$

$\propto s_1$

[Fig.13]

8

6

44

44

6

44

44

8

44

44

$\Phi$

$Q$

[Fig.14]

[Fig.15]

[Fig.16]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **GRIMSMO et al.** Quantum Error Correction with the Gottesman-Kitaev-Preskill Code. *ARXIV.ORG*
- **CAMPAGNE-IBARCQ P et al.** A stabilized logical quantum bit encoded in grid states of a superconducting cavity. *ARXIV.ORG*
- **FOSTER, R. M**. A reactance theorem. *Bell System Technical Journal*, November 1924 (2), 259-267